Europäisches Patentamt

European Patent Office

Office européen des brevets

(11) Publication number: 0 637 862 A2

# EUROPEAN PATENT APPLICATION

(21) Application number: 94111892.9

(22) Date of filing: 29.07.94

(51) Int. Cl.6: **H01S 3/19**, H01L 33/00, H01L 21/20, H01L 21/36

(30) Priority: 05.08.93 JP 194471/93
31.03.94 JP 62384/94

(43) Date of publication of application:
08.02.95 Bulletin 95/06

(84) Designated Contracting States:
DE GB NL

(71) Applicant: HITACHI, LTD.
6, Kanda Surugadai 4-chome
Chiyoda-ku,
Tokyo 101 (JP)

(72) Inventor: Goto, Jun
326, Dai-2 Kyoushin-ryo,
3-1-3, Higashi-koigakubo
Kokubunji-shi,
Tokyo 185 (JP)
Inventor: Migita, Masahito
1200-22, Narahara-cho
Hachiouji-shi,
Tokyo 193 (JP)
Inventor: Taike, Akira, No. 7, Hitachi
Kitanohara-shataku, 6-12-3,
Higashi-koigakubo
Kokubunji-shi,
Tokyo 185 (JP)
Inventor: Momose, Masayuki
5-6-25, Izumi-cho
Houya-shi,
Tokyo 202 (JP)
Inventor: Nakatsuka, Shin'ichi
302, Nyuuraifu-manshon-Hinodai,
1-19-1, Hinodai
Hino-shi,
Tokyo 191 (JP)

(74) Representative: Strehl Schübel-Hopf Groening
& Partner
Maximilianstrasse 54
D-80538 München (DE)

(54) Semiconductor laser device and method of fabricating the laser device.

(57) In a buried type semiconductor laser device composed of a II-VI compound semiconductor, a buried layer 9 - 11 is made of a II-VI compound semiconductor having a refraction factor lower than that of an active layer of the laser device. The buried layer has a forbidden band width larger than that of an active layer of the laser device. The buried layer has such a composition that the lattice constant thereof is substantially matched to that of a substrate on which the laser device is grown. The buried layer has an electric resistance high enough not to exert an effect on the operation of the laser composed of an n-type clad-active layer-a p-type clad.

FIG. 1

## Background of the Invention

The present invention relates to a semiconductor laser device, and particularly to a short wave semiconductor laser device composed of a II-VI compound semiconductor used for information processing terminal equipment such as an optical disk, laser beam printer or laser television, and a method of fabricating the laser device.

A conventional semiconductor laser device using a II-VI compound semiconductor has a gain waveguiding type electrode stripe structure in which an alloy of ZnCdSSe or ZnMgSSe is grown on a GaAs substrate. The former structure using ZnCdSSe has been described, for example in Unexamined Japanese Patent Publication No. HEI 3-91270; and the latter structure using ZnMgSSe has been described, for example in Unexamined Japanese Patent Publication No. HEI 5-75217. In these structures, a continuous oscillation at low temperatures or a pulse oscillation at room temperature can be realized at an oscillation wavelength of about 500 nm (ZnCdSSe system) or about 450 nm (ZnMgSSe system).

These structures, however, have the following disadvantages. The threshold current is relatively large because of the gain waveguiding type. It is difficult to form an ohmic contact with an electrode material because of the wide gap material. The thermal expansion strain remains in the device because a III-V compound semiconductor is used as a growth substrate. It is difficult to design a laser structure with a large band continuity between a clad layer and an active layer for the ZnCdSSe system being easy in the conducting control compared with the ZnMgSSe system, resulting in the insufficient confinement of injected charge and light. Because of these disadvantages, the above structures are difficult to achieve the continuous oscillation at room temperature and the operation with a high reliability.

## Summary of the Invention

An object of the present invention is to provide a short wave semiconductor laser device composed of a II-VI compound semiconductor capable of solving the above-described problems.

The present invention basically includes a buried type semiconductor laser structure using a II-VI compound semiconductor for reducing the threshold current and improving the reliability, wherein a multi-layer reflection film is provided for achieving the short wave oscillation. Concretely, in a buried type semiconductor laser device composed of a II-VI compound semiconductor, a buried layer is made of a II-VI compound semiconductor having a refraction factor lower than that of an active layer of the laser device. The buried layer has a forbidden band width larger than that of an active layer of the laser device. The buried layer has such a composition that the lattice constant thereof is substantially matched to that of a substrate on which the laser device is grown, and also it has an electric resistance high enough not to exert an effect on the operation of the laser composed of an n-type clad-active layer-a p-type clad. The buried layer is made of a II-VI compound semiconductor having a conducting type opposed to that of a clad layer being horizontally contacted with the surface of a substrate or to that of an active layer. The method of forming a buried layer includes the steps of: forming sulfur atoms or a layer of sulfur atoms on a II-VI compound semiconductor; introducing the II-VI compound semiconductor in a thin film deposition apparatus; removing the sulfur atoms or a layer of sulfur atoms by a suitable amount using electromagnetic wave, corpuscular beam, heat or solution; and growing or depositing a new material of a II-VI compound semiconductor, a III-V compound, a IV compound, a IV-VI compound, or a II-VII compound. At this time, the sulfur atoms or a layer of sulfur atoms formed on the II-VI compound semiconductor are removed at a temperature of 400°C or less, and a new material of a II-VI compound semiconductor, a III-V compound, a IV compound, a IV-VI compound, or a II-VII compound is grown or deposited on the exposed surface. A material, which is used for formation of a protection film or multi-layer reflection film at the end surface of a resonator, contains one kind or more of II-VI compounds having a forbidden band width larger than that of an active layer, such as ZnS or MgS; one kind or more of IV-VI compounds having a forbidden band width larger than that of an active layer, such as $SiO_2$ or $TiO_2$; one kind or more of II-VII compounds having a forbidden band width larger than that of an active layer, such as $MgF_2$ or $CaF_2$; or one kind or more of IV compounds having a forbidden band width larger than that of an active layer, such as C, SiCx or SiNx.

To form an electrode having a small contact resistance on a p-type clad layer having a wide forbidden band width, a cap layer is made of a P-type CdSSe alloy having a small energy difference on the valency electron side to the clad layer and a relatively narrow forbidden band width. The cap layer made of an alloy with a gradient composition can be easily fabricated by exposing the surface of a clad layer to a molecular beam of Cd or Te. Namely, in forming an electrode to the II-VI compound semiconductor, a layer including an alloy of CdSSe is grown on the II-VI compound semiconductor as a cap layer, and then a metal film as an electrode is deposited on this layer. In this case, the II-VI compound semiconductor is exposed to a molecular beam or a gas containing Cd or Te in a crystal deposition apparatus, and a metal film as an electrode is deposited on the surface thereof.

For reducing a strain generated in the device due to a large difference in a linear thermal expansion coefficient between a substrate of GaAs, that is, a III-V compound and a II-VI compound, a strain superlattice is introduced in the hetero-interface. Namely, in epitaxially growing a device composed of a II-VI compound semiconductor on a substrate made of a IV such as Si or a III-V compound semiconductor such as GaAs or InP, a strained supperlattice including at least one thin film of II-VI compound semiconductor is introduced in the hetero-interface as a region for reducing a strain caused by thermal expansion or contraction.

To realize the sufficient confinement of injected charge in the ZnCdSSe based laser structure, there is provided an asymmetric double hetero structure in which the ZnSSe layer is used as the p-type clad layer and the ZnCdSSe layer is used as the n-type clad layer. Moreover, to sufficient confine a light, the ZnCdSSe based laser structure adopts a GRIN-SCH structure using a supperlattice with the film thickness gradually changed as a light confinement layer. Namely, a double hetero type semiconductor laser device using a II-VI compound semiconductor composed of an alloy of ZnMgCdSSe, includes an n-type clad layer, a p-type clad layer and an active layer, wherein each of said n-type and p-type clad layers has a lattice constant substantially matched to that of a substrate crystal or a buffer layer formed at the hetero-interface, and which has a forbidden band width larger than that of an active layer; said n-type and p-type clad layers are different in the alloy composition from each other; and the difference ($\Delta Ev = Ev_{act} - Ev_{clad}$) in the energy of the valency electron band between said n-type clad layer and said active layer is positive, and the difference ($\Delta Ec = Ec_{clad} - Ec_{act}$) in the energy of the conducting band between said p-type clad layer and said active layer is positive. Moreover, in the semiconductor laser device having a GRIN-SCH structure using a II-VI compound semiconductor, the light guide layer is made of a superlattice.

In the present invention, a buried type laser structure enables the effective current constriction. Moreover, by provision of a refraction factor waveguiding type structure for waveguide of a light, it is possible to reduce the threshold current, and to improve the laser light characteristics. To fabricate the buried structure, the re-growth technique of the buried layer is required. However, by processing the surface of a II-VI compound forming the mesa structure with sulfur, it becomes possible to obtain the cleaned surface through heating at a temperature near the growth temperature of II-VI compound (400 °C or less).

Moreover, by forming a reflection multi-layer film or protection film not to absorb a short wave light on the end surface of the resonator, it is possible to reduce the threshold current, and to suppress the breakage of the end surface. In this case, by use of a thin film of ZnS or MgS excellent in adhesiveness, or a diamond based (poly-C, SiC) thin film having a high refraction factor and a resistance to deterioration, and by processing the end surface with sulfur prior to formation of these thin films, it becomes possible to obtain a high reliability.

In the formation of an electrode on the p-type crystal, by coating the p-type crystal with the material of an alloy of CdSSe being small in the energy difference on the valency electron band side with respect to the p-type crystal, it becomes possible to effectively inject positive holes. On the other hand, when ZnTe being large in the energy difference on the valency electron band side and being easy to obtain the p-type conduction is used, an alloy with a gradient composition must be fabricated. According to the present invention, it becomes possible to easily fabricate such an alloy with a gradient composition.

As a typical example, between a substrate of GaAs (III-V compound) and ZnSe or ZnS (II-VI compound), there is a mismatch in the thermal expansion coefficient of about 40%. Accordingly, even when the lattice constant of the ZnSSe alloy is matched to that of the GaAs substrate at the growth temperature of about 300 °C, there is generated a lattice strain at room temperature where the device is used. To reduce the strain, by introducing, for example a ZnSe-ZnSSe strained superlattice in the hetero-interface, it becomes possible to suppress the propagation of the expansion or contraction of the substrate to the device, and hence to improve the reliability of the semiconductor laser.

In a semiconductor laser of a ZnCdSSe system using clad layers having different alloy compositions, it is possible to achieve the lattice match to the substrate, and to effectively confine the injected charge. For example, when a ZnSSe alloy is used as the p-type clad layer, a ZnCdSe alloy is used as an active layer, and a ZnCdSSe alloy is used as an n-type clad layer, electrons can be confined by the electrical field formed in ZnSSe and positive holes can be confined by the electrical field formed in ZnCdSSe. Moreover, an asymmetric SCH structure is used to achieve the light confinement, wherein a ZnCdSSe n-type clad layer is used as a light guide layer, and an n-type ZnCdS alloy is used as a clad layer.

On the other hand, in the recent structure including a clad layer of ZnSSe, an active layer of ZnCdSe, and a light guide layer of ZnSe, the film thickness of the light guide layer is required to be more than the critical film thickness of ZnSe for effectively confining a light. In this regard, lattice defects in ZnSe present a problem. To cope with this problem, a superlattice composed of ZnSe-ZnSSe with the film thickness gradually changed is used as the light guide layer. This makes it possible to obtain a film thickness enough to confine a light without any generation of lattice defects, and to easily fabricate a GRIN-SCH type semiconductor device using molecular beam epitaxy which is difficult to fabricate an alloy having a gradient composition.

Brief Description of the Drawings

Fig. 1 is a semiconductor laser structure of a first embodiment of the present invention;
Fig. 2 is a bad structure of the semiconductor laser of the first embodiment of the present invention;
Fig. 3 is a semiconductor laser structure of a second embodiment of the present invention;
Fig. 4 is a structure of a supperlattice light guide layer of the second embodiment of the present invention;
Fig. 5 is a band structure of the semiconductor laser of the second embodiment of the present invention;
Fig. 6 is a semiconductor laser structure of a third embodiment of the present invention;
Fig. 7 is a semiconductor laser structure of a fourth embodiment of the present invention;
Fig. 8 is a semiconductor laser structure of a fifth embodiment of the present invention;
Fig. 9 is a semiconductor laser structure of a sixth embodiment of the present invention;
Fig. 10 is a semiconductor laser structure of a seventh embodiment of the present invention;
Fig. 11 is a semiconductor laser structure of an eighth embodiment of the present invention;
Fig. 12 is a semiconductor laser structure of a ninth embodiment of the present invention;
Fig. 13 is a semiconductor laser structure of a tenth embodiment of the present invention;
Fig. 14 is a semiconductor laser structure of an eleventh embodiment of the present invention;
Fig. 15 is a semiconductor laser structure of a twelfth embodiment; and
Fig. 16 is a semiconductor laser structure of a thirteenth embodiment of the present invention.

Description of the Preferred Embodiments

(Embodiment 1)

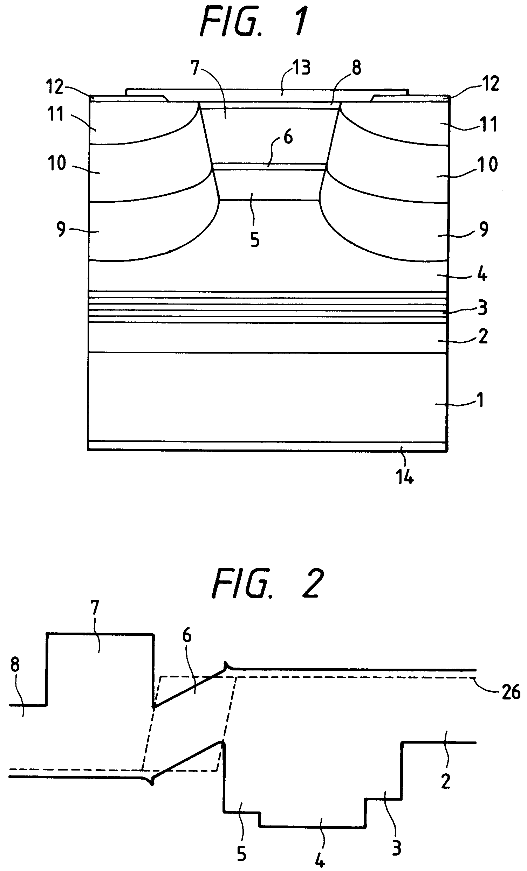

A first embodiment of the present invention will be described with reference to Fig. 1. On an n-type GaAs substrate 1, there were sequentially grown by molecular beam epitaxy, an Se doped GaAs buffer layer 2 (n = 1El8, 0.5 $\mu$m), a C$\ell$ doped ZnSe-ZnS$_{0.2}$Se$_{0.8}$ strained superlattice 3 (n = 5El8, 0.5 $\mu$m), a C$\ell$ doped Zn$_{0.5}$Cd$_{0.5}$S$_{0.9}$Se$_{0.1}$ clad layer 4 (n = 5El8, 1.5 $\mu$m), a C$\ell$ doped Zn$_{0.8}$Cd$_{0.2}$S$_{0.4}$Se$_{0.6}$ light guide layer 5 (n = 5El7, 0.5 $\mu$m), an undoped Zn$_{0.8}$Cd$_{0.2}$S$_{0.1}$Se$_{0.9}$ active layer 6 (0.01 $\mu$m), an N$_2$ doped ZnS$_{0.1}$Se$_{0.9}$ clad layer 7 (p = 1El8, 1.0 $\mu$m), and an N$_2$ doped CdSe cap layer 8 (p = 1El9, 0.01 $\mu$m).

Next, an SiO$_2$ film was formed on the above layers by vacuum vapor deposition. The SiO$_2$ film was made in the form of a stripe having a width of about 5 $\mu$m using the known photolithography. A reverse mesa structure having a depth of about 2.5 $\mu$m was then formed using a phosphoric acid based etching solution. This sample was then dipped in a (NH$_4$)$_2$Sx solution for several min and cleaned by an alcohol based solvent, and it was put in the molecular beam epitaxy system again.

This sample was heated at about 300°C to remove excessive sulfur. On this sample, there were sequentially grown, as buried layers, an N$_2$ doped Zn$_{0.5}$Cd$_{0.5}$S$_{0.9}$Se$_{0.1}$ block layer 9 (p = 1El6, 1.5 $\mu$m), a C$\ell$ doped ZnS$_{0.1}$Se$_{0.9}$ block layer 10 (n = 1El6, 1.0 $\mu$m), and an N$_2$ doped ZnS$_{0.1}$Se$_{0.9}$ block layer 11 (p = 1El6, 0.5 $\mu$m). The SiO$_2$ film was then removed using a fluoric acid based etching solution, and an SiO$_2$ film 12 was formed on the sample by vacuum vapor deposition.

Next, a striped hole having a width of about 5 $\mu$m was opened in the SiO$_2$ film 12 to the above stripe using the known photolithography. The sample was then dipped in the (NH$_4$)$_2$Sx solution for several min and cleaned with alcohol based solvent. After that, a Ti-Pt-Au multi-layer electrode 13 was deposited to a thickness of about 1 $\mu$m by vacuum vapor deposition. Moreover, an AuGe-Ni-Au multi-layer electrode 14 was deposited on the rear surface of the GaAs substrate which was polished to a thickness of 100 $\mu$m, after which the sample was cleaved to form a laser structure having a length of 400 $\mu$m.

The device thus obtained was dipped in the (NH$_4$)$_2$Sx solution for several min and cleaned with alcohol based solvent. A ZnS-SiO$_2$ multi-layer reflection film was then formed at the end surface of the resonator by sputtering.

The band structure of this structure in the laser oscillation state is shown in Fig. 2. Numeral 26 designates the Fermi level. Positive holes injected by the p-type semiconductor layer are confined by an electric potential formed on the valency electron band side by the p-n junction and the junction between the $Zn_{0.8}Cd_{0.2}S_{0.4}Se_{0.6}$ light guide layer and the $Zn_{0.8}Cd_{0.2}S_{0.1}Se_{0.9}$ active layer. On the other hand, electrons injected from the n-type semiconductor are confined by an electric potential formed on the conducting band side by the p-n junction and the junction between the $ZnS_{0.1}Se_{0.9}$ clad layer and the $Zn_{0.8}Cd_{0.2}S_{0.1}Se_{0.9}$ active layer. Thus, this structure enables the laser oscillation at a wavelength of 490 nm.

(Embodiment 2)

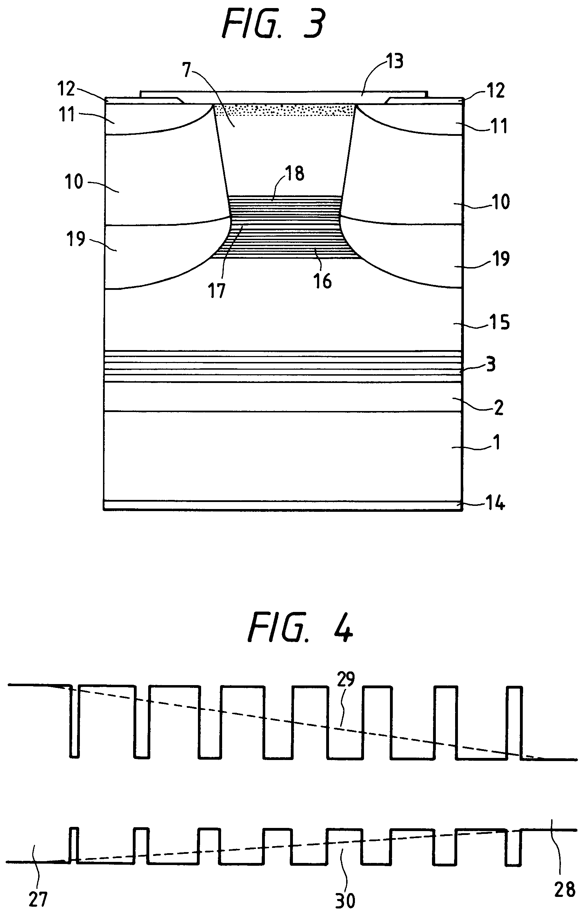

A second embodiment of the present invention will be described with reference to Fig. 3. On an n-type GaAs substrate 1, there were sequentially grown by molecular beam epitaxy, an Se doped GaAs buffer layer 2 (n = 1El8, 0.5 $\mu$m), a C$\ell$ doped $ZnSe$-$ZnS_{0.2}Se_{0.8}$ strained superlattice 3 (n = 1El8, 0.5 $\mu$m), a C$\ell$ doped $ZnS_{0.1}Se_{0.9}$ clad layer 15 (n = 1El8, 1.5 $\mu$m), a C$\ell$ doped $ZnSe$-$Zn_{0.8}Cd_{0.2}Se$ supperlattice light guide layer 16 (n = 5El7, 0.5 $\mu$m), an undoped $Zn_{0.8}Cd_{0.2}Se$ active layer 17 (0.01 $\mu$m), an $N_2$ doped $ZnSe$-$Zn_{0.8}Cd_{0.2}Se$ supperlattice light guide layer 18 (p = 5El7, 0.5 $\mu$m), and an $N_2$ doped $ZnS_{0.1}Se_{0.9}$ clad layer 7 (p = 1El8, 1.5 $\mu$m). The surface of the sample was then irradiated with molecular beams of Te for several tens min while keeping the sample temperature at the crystal growth temperature. By this processing, a p-type ZnSeTe alloy having a gradient composition was formed on the surface of the sample.

An $SiO_2$ film was formed on the sample by vacuum vapor deposition. The $SiO_2$ film was made in the form of a stripe having a width of about 5 $\mu$m using the known photolithography. A reverse mesa structure having a depth of about 3.0 $\mu$m was then formed using a phosphoric acid based etching solution. The sample was then dipped in a $(NH_4)_2Sx$ solution for several min and cleaned by an alcohol based solvent, and it was put in the molecular beam epitaxy system again.

The sample was heated at about 300°C to remove excessive sulfur. On the sample, there were sequentially grown, as buried layers, an $N_2$ doped $ZnS_{0.1}Se_{0.9}$ block layer 19 (p = 1El6, 1.0 $\mu$m), a C$\ell$ doped $ZnS_{0.1}Se_{0.9}$ block layer 10 (n = 1El6, 1.5 $\mu$m), an $N_2$ doped $ZnS_{0.1}Se_{0.9}$ block layer 11 (p = 1El6, 0.5 $\mu$m). The $SiO_2$ film was then removed using a fluoric acid based etching solution, and an $SiO_2$ film 12 was formed on the surface of the sample by vacuum vapor deposition.

Next, a striped hole having a width of about 5 $\mu$m was opened in the $SiO_2$ film 12 to the above stripe using the known photolithography. The sample was then dipped in a $(NH_4)_2Sx$ solution for several min and cleaned with alcohol based solvent. After that, a Ti-Pt-Au multi-layer electrode 13 was deposited to a thickness of about 1 $\mu$m by vacuum vapor deposition. Moreover, an AuGe-Ni-Au multi-layer electrode 14 was deposited on the rear surface of the GaAs substrate which was polished to a thickness of 100 $\mu$m, after which the sample was cleaved to form a laser structure having a length of 400 $\mu$m.

The device thus obtained was dipped in the $(NH_4)_2Sx$ solution for several min and cleaned with alcohol based solvent. An SiNx-SiCx multi-layer reflection film was then formed at the end surface of the resonator by plasma CVD.

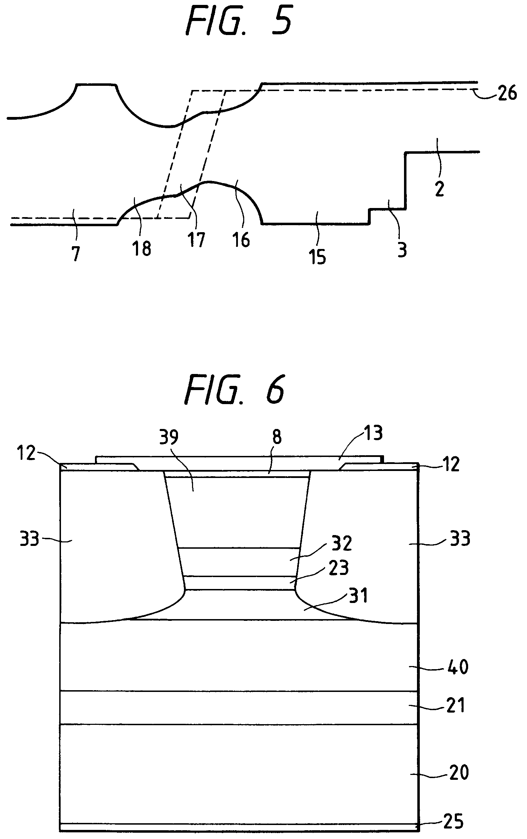

The $ZnSe$-$Zn_{0.8}Cd_{0.2}Se$ supperlattice light guide layer used in this structure is shown in Fig. 4. In this figure, numeral 27 designates $ZnSe$, 28 is $Zn_{0.8}Cd_{0.2}Se$, 29 is the lower end of an apparent conducting band, and 30 is the upper end of an apparent valency electron band. As shown in the figure, the structure in which the film thickness is gradually changed has the same effect as that of the alloy having the gradient composition. The laser of this structure has a band structure shown in Fig. 5. In this figure, numeral 26 designates the Fermi level. By provision such a GRIN-SCH type semiconductor laser, it is possible to eliminate lattice defects of the light guide layer which has conventionally presented a problem, and hence to improve the reliability of the device.

(Embodiment 3)

A third embodiment of the present invention will be described with reference to Fig. 6. On an n-type ZnSe substrate 20, there were sequentially grown by molecular beam epitaxy, a C$\ell$ doped ZnSe buffer layer 21 (n = 1El8, 0.5 $\mu$m), a C$\ell$ doped $Mg_{0.2}Zn_{0.8}S_{0.3}Se_{0.7}$ clad layer 39 (n = 1El8, 1.0 $\mu$m), a C$\ell$ doped $Zn_{0.9}Cd_{0.1}S_{0.2}Se_{0.8}$ light guide layer 31 (n = 5El7, 0.5 $\mu$m), an undoped ZnSe active layer 23 (0.2 $\mu$m), an $N_2$ doped $ZnS_{0.9}Cd_{0.1}S_{0.2}Se_{0.8}$ light guide layer 32 (p = 5El7, 0.5 $\mu$m), an $N_2$ doped $Mg_{0.2}Zn_{0.8}S_{0.3}Se_{0.7}$ clad layer 40 (p = 1El8, 1.0 $\mu$m), and an $N_2$ doped CdSe cap layer 8 (p = 1El9, 0.01 $\mu$m).

An $SiO_2$ film was formed on the above layers by vacuum vapor deposition. The $SiO_2$ film was made in the form of a stripe having a width of about 5 $\mu$m using the known photolithography. A reverse mesa structure having a depth of about 2.0 $\mu$m was then formed using a sulfuric acid based etching solution. This sample was then dipped in a $(NH_4)_2Sx$ solution for several min and cleaned by an alcohol based solvent, and it was put in the molecular beam epitaxy system again.

This sample was heated at about 300°C to remove excessive sulfur. On this sample, an undoped $MgS_{0.9}Se_{0.1}$ block layer 33 (n/p < 1 EI5, 2.0 $\mu$m) was grown as a buried layer. The $SiO_2$ film was then removed using a fluoric acid based etching solution, and an $SiO_2$ film 12 was formed on the surface of the sample by vacuum vapor deposition.

Next, a striped hole having a width of about 5 $\mu$m was opened in the $SiO_2$ film 12 to the above stripe using the known photolithography. The sample was then dipped in a $(NH_4)_2Sx$ solution for several min and cleaned with alcohol based solvent. After that, a Ti-Pt-Au multi-layer electrode 13 was deposited to a thickness of about 1 $\mu$m by vacuum vapor deposition. Moreover, an AuGe-Ni-Au multi-layer electrode 25 was deposited on the rear surface of the GaAs substrate which was polished to a thickness of 100 $\mu$m, after which the sample was cleaved to form a laser structure having a length of 500 $\mu$m.

The device thus obtained was dipped in the $(NH_4)_2Sx$ solution for several min and cleaned with alcohol based solvent, and a $SiO_2$-$TiO_2$ multi-layer reflection film was formed at the end surface of the resonator by vacuum vapor deposition.

The semiconductor laser device of this structure is capable of continuously oscillating a blue laser of a single vertical mode with an oscillation wavelength of about 450 nm at room temperature.

(Embodiment 4)

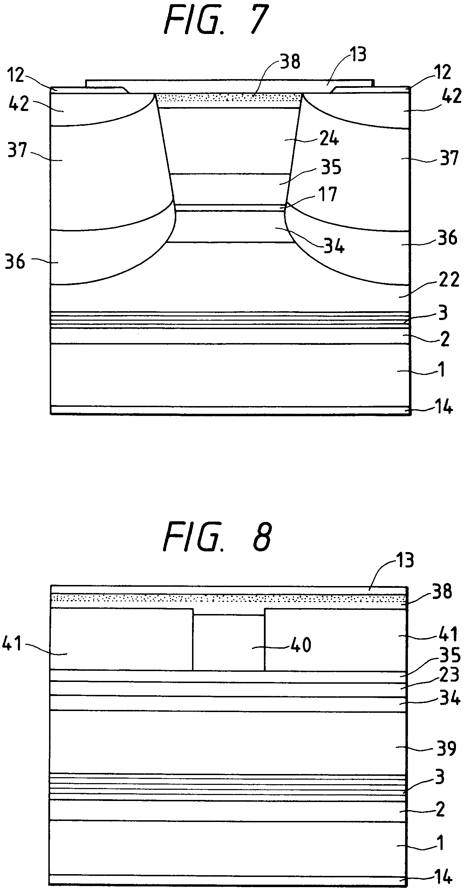

A fourth embodiment of the present invention will be described with reference to Fig. 7. On an n-type GaAs substrate 1, there were sequentially grown by molecular beam epitaxy, an Se doped GaAs buffer layer 2 (n = 1EI8, 0.5 $\mu$m), a $C\ell$ doped $ZnSe$-$ZnS_{0.2}Se_{0.8}$ strained superlattice 3 (n = 1EI8, 0.5 $\mu$m), a $C\ell$ doped $Mg_{0.1}Zn_{0.9}S_{0.2}Se_{0.8}$ clad layer 22 (n = 1EI8, 1.5 $\mu$m), a $C\ell$ doped $ZnS_{0.1}Se_{0.9}$ light guide layer 34 (n = 5EI7, 0.3 $\mu$m), an undoped $Zn_{0.8}Cd_{0.2}Se$ active layer 17 (0.01 $\mu$m), an $N_2$ doped $ZnS_{0.1}Se_{0.9}$ light guide layer 35 (p = 5EI7, 0.3 $\mu$m), an $N_2$ doped $Mg_{0.1}Zn_{0.9}S_{0.2}Se_{0.8}$ clad layer 24 (p = 1EI8, 1.0 $\mu$m), and an $N_2$ doped $ZnSe$ cap layer 38 (p = 5EI8, 0.1 $\mu$m). The surface of the sample was irradiated with molecular beams of Te for several tens min while keeping the sample temperature at the crystal growth temperature, and then was cooled to a temperature near room temperature. By this processing, a p-type $ZnSeTe$ alloy having a gradient composition was formed on the surface of the sample.

Next, an $SiO_2$ film was formed on the sample by plasma CVD. The $SiO_2$ film was made in the form of a stripe having a width of about 5 $\mu$m using the known photolithography. A reverse mesa structure having a depth of about 2 $\mu$m was then formed using a sulfuric acid based etching solution. This sample was then dipped in a $(NH_4)_2Sx$ solution for several min and cleaned by an alcohol based solvent, and it was put in the metal-organic vapor deposition system.

This sample was irradiated with hydrogen radicals while being heated at about 300°C to remove excessive sulfur. On this sample, there were sequentially grown, as buried layers, an $N_2$ doped $Mg_{0.2}Zn_{0.8}S_{0.3}Se_{0.7}$ block layer 36 (p = 1EI6, 1.0 $\mu$m), a $C\ell$ doped $Mg_{0.2}Zn_{0.8}S_{0.3}Se_{0.7}$ block layer 37 (n = 1EI6, 1.0 $\mu$m), an $N_2$ doped $Mg_{0.2}Zn_{0.8}S_{0.3}Se_{0.7}$ block layer 42 (p = 1EI6, 0.5 $\mu$m). The $SiO_2$ film was then removed using a fluoric acid based etching solution, and an $SiO_2$ film 12 was formed on the sample by plasma CVD.

Next, a striped hole having a width of about 5 $\mu$m was opened in the $SiO_2$ film 12 to the above stripe using the known photolithography. The sample was then dipped in a $(NH_4)_2Sx$ solution for several min and cleaned with alcohol based solvent. After that, a Ti-Pt-Au multi-layer electrode 13 was deposited to a thickness of about 1 $\mu$m by vacuum vapor deposition. Moreover, an AuGe-Ni-Au multi-layer electrode 14 was deposited on the rear surface of the GaAs substrate which was polished to a thickness of 100 $\mu$m, after which the sample was cleaved to form a laser structure with a length of 400 $\mu$m.

The device thus obtained was dipped in the $(NH_4)_2Sx$ solution for several min and cleaned with alcohol based solvent, and a $CaF_2$-$SiO_2$ multi-layer reflection film was formed at the end surface of the resonator by sputtering.

The semiconductor laser of this structure is capable of continuously oscillating at room temperature a marine blue laser of a single vertical mode having a characteristic of a threshold current of 50 mA, a drive voltage 4V, and an oscillation wavelength of 510 nm.

(Embodiment 5)

A fifth embodiment of the present invention will be described with reference to Fig. 8. On an n-type GaAs substrate 1, there were sequentially grown by molecular beam epitaxy, an Se doped GaAs buffer layer 2 (n = 1EI8, 0.5 $\mu$m), a $C\ell$ doped $ZnSe$-$ZnS_{0.2}Se_{0.8}$ strained superlattice 3 (n = 1EI8, 0.5 $\mu$m), a $C\ell$ doped $Mg_{0.2}Zn_{0.8}S_{0.3}Se_{0.7}$ clad layer 39 (n = 1EI8, 1.5 $\mu$m), a $C\ell$ doped $ZnS_{0.1}Se_{0.9}$ light guide layer 34 (n = 5EI7, 0.3 $\mu$m), an undoped $ZnSe$ active layer 23 (0.1 $\mu$m), an $N_2$ doped $ZnS_{0.1}Se_{0.9}$ light guide layer 35 (p = 5EI8, 0.3 $\mu$m), an $N_2$ doped $Mg_{0.2}Zn_{0.8}S_{0.3}Se_{0.7}$ clad layer 40 (p = 1EI8, 1.0 $\mu$m), and an $N_2$ doped $ZnSe$ cap

layer 38 (p = 5El8, 0.05 $\mu$m). Next, an $SiO_2$ film was formed on the above layers by plasma CVD. The $SiO_2$ film was made in the form of a stripe having a width of about 5 $\mu$m using the known photolithography. A reverse mesa structure having a depth of about 1 $\mu$m was formed using a sulfuric acid based selective etching solution. This sample was then dipped in a $(NH_4)_2Sx$ solution for several min and cleaned by an alcohol based solvent, and it was put in the metal-organic vapor deposition system.

The sample was irradiated with hydrogen radicals while being heated at about 300°C to remove excessive sulfur. On this sample, a $C\ell$ doped $Mg_{0.3}Zn_{0.7}S_{0.4}Se_{0.6}$ block layer 41 (n = 1El6, 1.0 $\mu$m) was grown as a buried layer. The $SiO_2$ film was then removed using a fluoric acid based etching solution, and the sample was dipped in a $(NH_4)_2Sx$ solution for several minutes and cleaned using an alcohol solvent, and it was put in the molecular beam epitaxy system.

The sample was irradiated with hydrogen radicals while being heated at about 300°C to remove excessive sulfur, and an $N_2$ doped ZnSe cap layer 38 (p = 5El8, 0.1 $\mu$m) was grown on the this sample. The surface of the sample was irradiated with molecular beams of Te for several tens min while keeping the sample temperature at the crystal growth temperature, and was then cooled to a temperature near room temperature. By this processing, a p-type ZnSeTe alloy having a gradient composition was formed on the surface of the sample.

Next, a Ti-Pt-Au multi-layer electrode 13 was deposited to a thickness of about 1 $\mu$m by vacuum vapor deposition. Moreover, an AuGe-Ni-Au multi-layer electrode 14 was deposited on the rear surface of the GaAs substrate which was polished to a thickness of 100 $\mu$m, after which the sample was cleaved to form a laser structure having a length of 400 $\mu$m.

The device thus obtained was dipped in the $(NH_4)_2Sx$ solution for several min and cleaned with alcohol based solvent, and a $ZnS-SiO_2$ multi-layer reflection film was formed at the end surface of the resonator by sputtering.

The semiconductor laser of this structure is capable of continuously oscillating at room temperature a marine blue laser of a single vertical mode having a characteristic of a threshold current of 60 mA, a drive voltage 5V, and an oscillation wavelength of 450 nm.

(Embodiment 6)

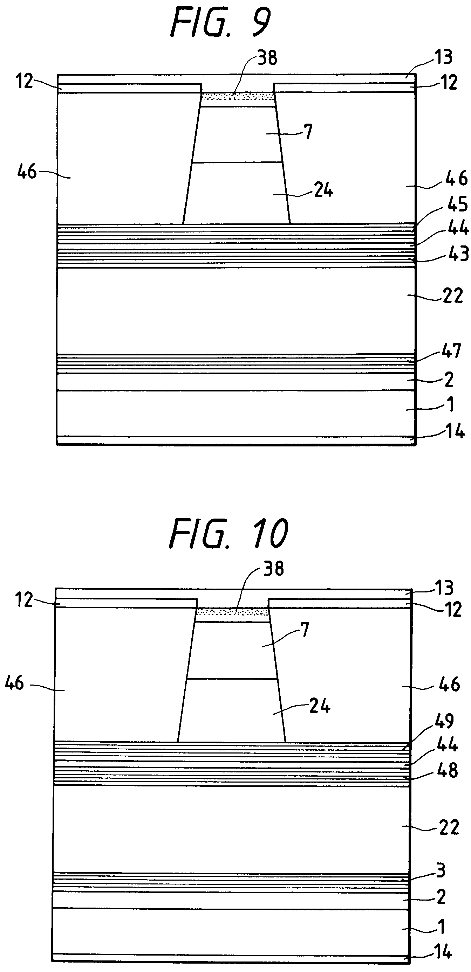

A sixth embodiment of the present invention will be described with reference to Fig. 9. On an n-type GaAs substrate 1, there were sequentially grown by molecular beam epitaxy, an Se doped GaAs buffer layer 2 (n = 1El8, 0.5 $\mu$m), a strained supperlattice 47 (n = 1El8, 0.03 $\mu$m) of five cycles of $C\ell$ doped $ZnS_{0.1}Se_{0.9}$ (5 nm) - $Zn_{0.7}Cd_{0.3}S_{0.1}Se_{0.9}$ (5 nm), a $C\ell$ doped $Mg_{0.1}Zn_{0.9}S_{0.2}Se_{0.8}$ clad layer 22 (n = 1El8, 1.5 $\mu$m), a supperlattice light guide layer 43 (n = 5El7, 0.1 $\mu$m) of seven cycles of $C\ell$ doped $ZnS_{0.1}Se_{0.9}$ - (10 nm) - $Zn_{0.7}Cd_{0.3}S_{0.1}Se_{0.9}$ (3 nm), an undoped $Zn_{0.7}Cd_{0.3}Se$ active layer 44 (0.01 $\mu$m), a supperlattice light guide layer 45 (p = 5El7, 0.1 $\mu$m) of seven cycles of $N_2$ doped $ZnS_{0.1}Se_{0.9}$ (10 nm) - $Zn_{0.7}Cd_{0.3}S_{0.1}Se_{0.9}$ (3 nm), an $N_2$ doped $Mg_{0.1}Zn_{0.9}S_{0.2}Se_{0.8}$ clad layer 24 (p = 1El7, 1.0 $\mu$m), an $N_2$ doped $ZnS_{0.1}Se_{0.9}$ clad layer 7 (p = 5El7, 0.5 $\mu$m), and a ZnSe cap layer 38 (p = 1El8, 0.1 $\mu$m). The surface of the sample was irradiated with molecular beams of Te for several tens min while keeping the sample temperature at the crystal growth temperature, and was then cooled to a temperature near room temperature. By this processing, a p-type ZnSeTe alloy with a gradient composition was formed on the surface of the sample. Next, an $SiO_2$ film was formed on the sample by plasma CVD. The $SiO_2$ film was made in the form of a stripe having a width of about 5 $\mu$m using the known photolithography. A reverse mesa structure having a depth of about 1.5 $\mu$m was then formed using a bromine based selective etching solution. The sample was then dipped in a $(NH_4)_2Sx$ solution for several min and cleaned with an alcohol based solvent, and it was put in the metal-organic vapor deposition system.

This sample was irradiated with hydrogen radicals while being heated at about 300°C to remove excessive sulfur. On this sample, an undoped $Mg_{0.2}Zn_{0.7}S_{0.3}Se_{0.7}$ block layer 46 (n = 1El4, 1.5 $\mu$m) was grown as a buried layer. Next, an $SiO_2$ film 12 was formed on the buried layer by plasma CVD, and a striped hole having a width of about 5 $\mu$m was formed in the $SiO_2$ film using the known photolithography.

Next, a Ti-Pt-Au multi-layer electrode 13 was deposited to a thickness of about 1 $\mu$m by vacuum vapor deposition. Moreover, an AuGe-Ni-Au multi-layer electrode 14 was deposited on the rear surface of the GaAs substrate which was polished to a thickness of 100 $\mu$m, after which the sample was cleaved to form a laser structure having a length of 1000 $\mu$m.

The device thus obtained was dipped in the $(NH_4)_2Sx$ solution for several min and cleaned with alcohol based solvent, and an $SiNx-SiO_2$ multi-layer reflection film was formed at the end surface of the resonator by sputtering.

The semiconductor laser of this structure is capable of continuously oscillating at room temperature a marine blue laser of a single vertical mode having a characteristic of a threshold current of 2 mA, a drive voltage 4V, and an oscillation wavelength of 500 nm.

(Embodiment 7)

A seventh embodiment of the present invention will be described with reference to Fig. 10. On an n-type GaAs substrate 1, there were sequentially grown by molecular beam epitaxy, an Se doped GaAs buffer layer 2 (n = 1EI8, 0.5 $\mu$m), a strained supperlattice 3 (n = 1EI8, 0.03 $\mu$m) of five cycles of C$\ell$ doped $ZnS_{0.1}Se_{0.9}$ (5 nm) - ZnSe (5 nm), a C$\ell$ doped $Mg_{0.1}Zn_{0.9}S_{0.2}Se_{0.8}$ clad layer 22 (n = 1EI8, 1.5 $\mu$m), a supperlattice light guide layer 48 (n = 5EI7, 0.1 $\mu$m) of ten cycles of C$\ell$ doped $ZnS_{0.1}Se_{0.9}$ (5 nm) - ZnSe (5 nm), an undoped $Zn_{0.7}Cd_{0.3}Se$ active layer 44 (0.01 $\mu$m), a supperlattice light guide layer 49 (p = 5EI7, 0.1 $\mu$m) of ten cycles of $N_2$ doped $ZnS_{0.1}Se_{0.9}$ (5 nm) - ZnSe (5 nm), an $N_2$ doped $Mg_{0.1}Zn_{0.9}S_{0.2}Se_{0.8}$ clad layer 24 (p = 1EI7, 1.0 $\mu$m), an $N_2$ doped $ZnS_{0.1}S_{0.9}$ clad layer 7 (p = 5EI7, 0.5 $\mu$m), and a ZnSe cap layer 38 (p = 1EI8, 0.1 $\mu$m). The surface of the sample was irradiated with molecular beams of Te for several tens min while keeping the sample temperature of at the crystal growth temperature, and was then cooled to a temperature near room temperature. By this processing, a p-type ZnSeTe alloy with a gradient composition was formed on the surface of the sample. Next, an $SiO_2$ film was formed on the sample by plasma CVD. The $SiO_2$ film was made in the form of a stripe having a width of about 5 $\mu$m using the known photolithography. A reverse mesa structure having a depth of about 1.5 $\mu$m was formed using a bromine based selective etching solution. This sample was then dipped in a $(NH_4)_2Sx$ solution for several min and cleaned with an alcohol based solvent, and it was put in the metal-organic vapor deposition system.

This sample was irradiated with hydrogen radicals while being heated at about 300°C to remove excessive sulfur. On this sample, an undoped $Mg_{0.2}Zn_{0.7}S_{0.3}Se_{0.7}$ block layer 46 (n = 1EI4, 1.5 $\mu$m) was grown as a buried layer. Next, an $SiO_2$ film 12 was formed on the buried layer by plasma CVD, and a striped hole having a width of about 5 $\mu$m was formed in the $SiO_2$ film using the known photolithography.

Next, a Ti-Pt-Au multi-layer electrode 13 was deposited to a thickness of about 1 $\mu$m by vacuum vapor deposition. Moreover, an AuGe-Ni-Au multi-layer electrode 14 was deposited on the rear surface of the GaAs substrate which was polished to a thickness of 100 $\mu$m, after which the sample was cleaved to form a laser structure with a length of 1000 $\mu$m.

The device thus obtained was dipped in the $(NH_4)_2Sx$ solution for several min and cleaned with alcohol based solvent, and an SiNx-SiO$_2$ multi-layer reflection film was formed at the end surface of the resonator by sputtering.

The semiconductor laser of this structure is capable of continuously oscillating at room temperature a marine blue of a single vertical mode having a characteristic of a threshold current of 2 mA, a drive voltage 4V, and an oscillation wavelength of 500 nm.

(Embodiment 8)

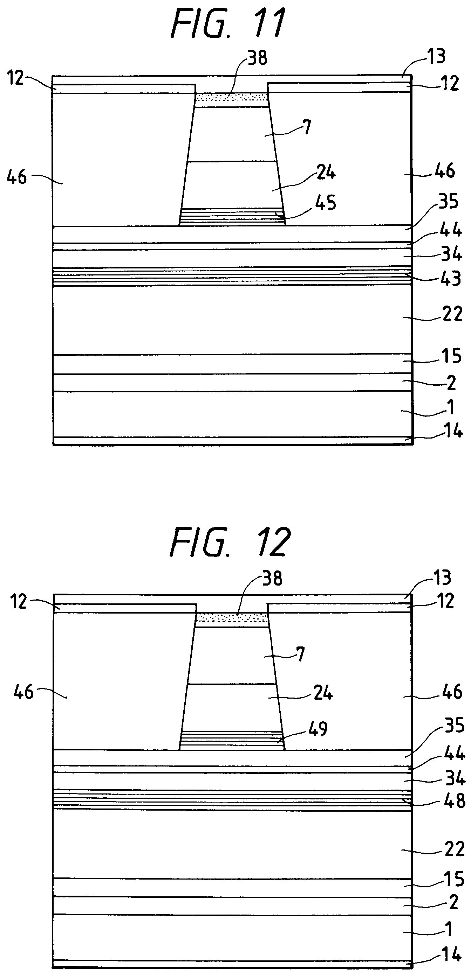

A eighth embodiment of the present invention will be described with reference to Fig. 11. On an n-type GaAs substrate 1, there were sequentially grown by molecular beam epitaxy, an Se doped GaAs buffer layer 2 (n = 1EI8, 0.5 $\mu$m), a C$\ell$ doped $ZnS_{0.1}Se_{0.9}$ clad layer 15 (n = 1 EI8, 0.1 $\mu$m), a C$\ell$ doped $Mg_{0.1}Zn_{0.9}S_{0.2}Se_{0.8}$ clad layer 22 (n = 1EI8, 1.5 $\mu$m), a supperlattice light guide layer 43 (n = 5EI7, 0.1 $\mu$m) of seven cycles of C$\ell$ doped $ZnS_{0.1}Se_{0.9}$ (10 nm) - $Zn_{0.7}Cd_{0.3}S_{0.1}Se_{0.9}$ (3 nm), a C$\ell$ doped $ZnS_{0.1}Se_{0.9}$ light guide layer 34 (n = 5EI7, 0.1 $\mu$m), an undoped $Zn_{0.7}Cd_{0.3}Se$ active layer 44 (0.01 $\mu$m), an $N_2$ doped $ZnS_{0.1}Se_{0.9}$ light guide layer 35 (p = 5EI7, 0.1 $\mu$m), a supperlattice light guide layer 45 (n = 5EI7, 0.1 $\mu$m) of seven cycles of $N_2$ doped $ZnS_{0.1}Se_{0.9}$ (10 nm) - $Zn_{0.7}Cd_{0.3}S_{0.1}Se_{0.9}$ (3 nm), an $N_2$ doped $Mg_{0.1}Zn_{0.9}S_{0.2}Se_{0.8}$ clad layer 24 (p = 1EI7, 1.0 $\mu$m), an $N_2$ doped $ZnS_{0.1}Se_{0.9}$ clad layer 7 (p = 5EI7, 0.5 $\mu$m), and a ZnSe cap layer 38 (p = 1EI8, 0.1 $\mu$m). The surface of the sample was irradiated with molecular beams of Te for several tens min while keeping the sample temperature at the crystal growth temperature, and was then cooled to a temperature near room temperature. By this processing, a p-type ZnSeTe alloy with a gradient composition was formed on the surface of the sample. Next, an $SiO_2$ film was formed on the above layers by plasma CVD. The $SiO_2$ film was made in the form of a stripe having a width of about 5 $\mu$m using the known photolithography. A reverse mesa structure having a depth of about 1.5 $\mu$m was formed using a bromine based selective etching solution. This sample was then dipped in a $(NH_4)_2Sx$ solution for several min and cleaned with an alcohol based solvent, and it was put in the metal-organic vapor deposition system.

This sample was irradiated with hydrogen radicals while being heated at about 300°C to remove excessive sulfur. On this sample, an undoped $Mg_{0.2}Zn_{0.7}S_{0.3}Se_{0.7}$ block layer 46 (n = 1EI4, 1.5 $\mu$m) was grown as a buried layer. Next, an $SiO_2$ film 12 was formed on the buried layer by plasma CVD, and a striped hole having a width of about 5

$\mu$m was formed on the SiO$_2$ film using the known photolithography.

Next, a Ti-Pt-Au multi-layer electrode 13 was deposited to a thickness of about 1 $\mu$m by vacuum vapor deposition. Moreover, an AuGe-Ni-Au multi-layer electrode 14 was deposited on the rear surface of the GaAs substrate which was polished to a thickness of 100 $\mu$m, after which the sample was cleaved to form a laser structure with a length of 1000 $\mu$m.

The device thus obtained was dipped in the (NH$_4$)$_2$Sx solution for several min and cleaned with alcohol based solvent, and an SiNx-SiO$_2$ multi-layer reflection film was formed at the end surface of the resonator by sputtering.

The semiconductor laser of this structure is capable of continuously oscillating at room temperature a marine blue laser of a single vertical mode having a characteristic of a threshold current of 2 mA, a drive voltage 4V, and an oscillation wavelength of 500 nm.

(Embodiment 9)

A ninth embodiment of the present invention will be described with reference to Fig. 12. On an n-type GaAs substrate 1, there were sequentially grown by molecular beam epitaxy, an Se doped GaAs buffer layer 2 (n = 1El8, 0.5 $\mu$m), a C$\ell$ doped ZnS$_{0.1}$Se$_{0.9}$ clad layer 15 (n = 1El8, 0.1 $\mu$m), a C$\ell$ doped Mg$_{0.1}$Zn$_{0.9}$S$_{0.2}$Se$_{0.8}$ clad layer 22 (n = 1El8, 1.5 $\mu$m), a strained supperlattice light guide layer 48 (n = 5El7, 0.1 $\mu$m) of ten cycles of C$\ell$ doped ZnS$_{0.1}$Se$_{0.9}$ (5 nm) - ZnSe (5 nm), a C$\ell$ doped ZnS$_{0.1}$Se$_{0.9}$ light guide layer 34 (n = 5El7, 0.1 $\mu$m), an undoped Zn$_{0.7}$Cd$_{0.3}$Se active layer 44 (0.01 $\mu$m), an N$_2$ doped ZnS$_{0.1}$Se$_{0.9}$ light guide layer 43 (p = 5El7, 0.1 $\mu$m), a supperlattice light guide layer 49 (p = 5El7, 0.1 $\mu$m) of ten cycles of N$_2$ doped ZnS$_{0.1}$Se$_{0.9}$ (5 nm) - ZnSe (5 nm), an N$_2$ doped Mg$_{0.1}$Zn$_{0.9}$S$_{0.2}$Se$_{0.8}$ clad layer 24 (p = 1El7, 1.0 $\mu$m), an N$_2$ doped ZnS$_{0.1}$Se$_{0.9}$ clad layer 7 (p = 5El7, 0.5 $\mu$m), and a ZnSe cap layer 38 (p = 1El8, 0.1 $\mu$m). The surface of the sample was irradiated with molecular beams of Te for several tens min while keeping the sample temperature at the crystal growth temperature, and was then cooled to a temperature near room temperature. By this processing, a p-type ZnSeTe alloy with a gradient composition was formed on the surface of the sample. Next, an SiO$_2$ film was formed on the sample by plasma CVD. The SiO$_2$ film was made in the form of a stripe having a width of about 5 $\mu$m using the known photolithography. A reverse mesa structure having a depth of about 1.5 $\mu$m was formed using a bromine based selective etching solution. This sample was then dipped in a (NH$_4$)$_2$Sx solution for several min and cleaned by an alcohol based solvent, and it was put in the metal-organic vapor deposition system.

The sample was irradiated with hydrogen radicals while being heated at about 300°C to remove excessive sulfur. On this sample, an undoped Mg$_{0.2}$Zn$_{0.7}$S$_{0.3}$Se$_{0.7}$ block layer 46 (n = 1El4, 1.5 $\mu$m) was grown as a buried layer. Next, an SiO$_2$ film 12 was formed on the buried layer by plasma CVD, and a striped hole having a width of about 5 $\mu$m was formed in the SiO$_2$ film using the known photolithography.

Next, a Ti-Pt-Au multi-layer electrode 13 was deposited to a thickness of about 1 $\mu$m by vacuum vapor deposition. Moreover, an AuGe-Ni-Au multi-layer electrode 14 was deposited on the rear surface of the GaAs substrate which was polished to a thickness of 100 $\mu$m, after which the sample was cleaved to form a laser structure with a length of 1000 $\mu$m.

The device thus obtained was dipped in the (NH$_4$)$_2$Sx solution for several min and cleaned with an alcohol based solvent, and an SiNx-SiO$_2$ multi-layer reflection film was formed at the end surface of the resonator by sputtering.

The semiconductor laser of this structure is capable of continuously oscillating at room temperature a marine blue laser of a single vertical mode having a characteristic of a threshold current of 2 mA, a drive voltage 4V, and an oscillation wavelength of 500 nm.

(Embodiment 10)

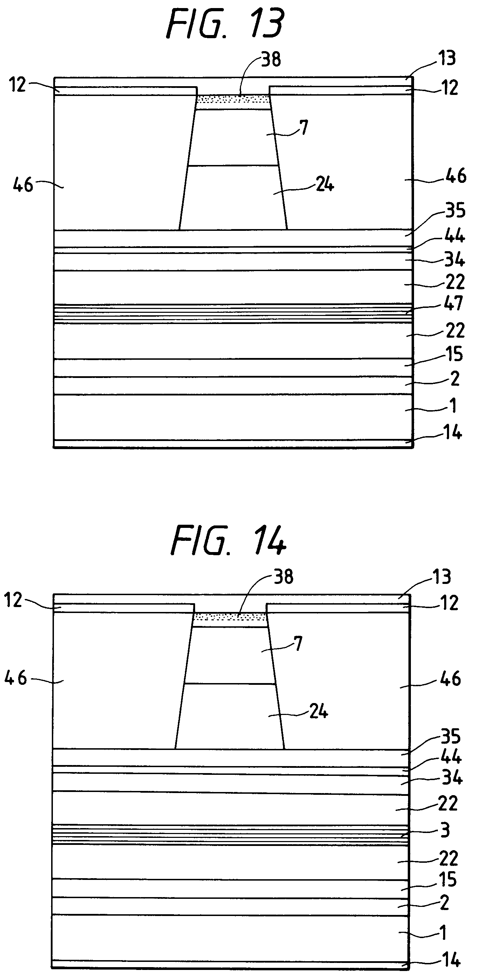

A tenth embodiment of the present invention will be described with reference to Fig. 13. On an n-type GaAs substrate 1, there were sequentially grown by molecular beam epitaxy, an Se doped GaAs buffer layer 2 (n = 1El8, 0.5 $\mu$m), a C$\ell$ doped ZnS$_{0.1}$Se$_{0.9}$ clad layer 15 (n = 1El8, 0.1 $\mu$m), a C$\ell$ doped Mg$_{0.1}$Zn$_{0.9}$S$_{0.2}$Se$_{0.8}$ clad layer 22 (n = 1El8, 0.5 $\mu$m), a strained supperlattice 47 (n = 5El7, 0.07 $\mu$m) of five cycles of C$\ell$ doped ZnS$_{0.1}$Se$_{0.9}$ (10 nm) - Zn$_{0.7}$Cd$_{0.3}$S$_{0.1}$Se$_{0.9}$ (3 nm), a C$\ell$ doped Mg$_{0.1}$Zn$_{0.9}$S$_{0.2}$Se$_{0.8}$ clad layer 22 (n = 1El8, 1.0 $\mu$m), a C$\ell$ doped ZnS$_{0.1}$Se$_{0.9}$ light guide layer 34 (n = 5 El7, 0.1 $\mu$m), an undoped Zn$_{0.7}$Cd$_{0.3}$Se active layer 44 (0.01 $\mu$m), an N$_2$ doped ZnS$_{0.1}$Se$_{0.9}$ light guide layer 35 (p = 5El7, 0.1 $\mu$m), an undoped Mg$_{0.1}$Zn$_{0.9}$S$_{0.2}$Se$_{0.8}$ clad layer 24 (p = 1El7, 1.0 $\mu$m), an N$_2$ doped ZnS$_{0.1}$Se$_{0.9}$ clad layer 7, and a ZnSe cap layer 38 (p = 1El8, 0.1 $\mu$m). The surface of the sample was irradiated with molecular beams of Te for several tens min while keeping the sample temperature at the crystal growth temperature, and was then cooled to a temperature near room temperature. By this processing, a p-type ZnSeTe alloy with a gradient composition was formed on the surface of the

sample. An $SiO_2$ film was formed on the sample by plasma CVD. The $SiO_2$ film was made in the form of a stripe having a width of about 5 $\mu$m using the known photolithography. A reverse mesa structure having a depth of about 1.5 $\mu$m was formed using a bromine based selective etching solution. This sample was then dipped in a $(NH_4)_2Sx$ solution for several min and cleaned by an alcohol based solvent, and it was put in the metal-organic vapor deposition system.

This sample was irradiated with hydrogen radicals while being heated at about 300°C to remove excessive sulfur. On the sample, an undoped $Mg_{0.2}Zn_{0.7}S_{0.3}Se_{0.7}$ block layer 46 (n = 1El4, 1.5 $\mu$m) was grown as a buried layer. Next, an $SiO_2$ film 12 was formed on the buried layer by plasma CVD, and a striped hole having a width of about 5 $\mu$m was formed on the $SiO_2$ film using the known photolithography.

Next, a Ti-Pt-Au multi-layer electrode 13 was deposited to a thickness of about 1 $\mu$m by vacuum vapor deposition. Moreover, an AuGe-Ni-Au multi-layer electrode 14 was deposited on the rear surface of the GaAs substrate which was polished to a thickness of 100 $\mu$m, after which the sample was cleaved to form a laser structure with a length of 1000 $\mu$m.

The device thus obtained was dipped in the $(NH_4)_2Sx$ solution for several min and cleaned with alcohol based solvent, and an SiNx-$SiO_2$ multi-layer reflection film was formed at the end surface of the resonator by sputtering.

The semiconductor laser of this structure is capable of continuously oscillating at room temperature a marine blue laser of a single vertical mode having a characteristic of a threshold current of 2 mA, a drive voltage 4V, and an oscillation wavelength of 500 nm.

(Embodiment 11)

An eleventh embodiment of the present invention will be described with reference to Fig. 14. On an n-type GaAs substrate 1, there were sequentially grown by molecular beam epitaxy, an Se doped GaAs buffer layer 2 (n = 1El8, 0.5 $\mu$m), a Cl doped $ZnS_{0.1}Se_{0.9}$ clad layer 15 (n = 1El8, 0.1 $\mu$m), a Cl doped $Mg_{0.1}Zn_{0.9}S_{0.2}Se_{0.8}$ clad layer 22 (n = 1El8, 0.5 $\mu$m), a strained supperlattice 3 (n = 5El7, 0.05 $\mu$m) of five cycles of Cl doped $ZnS_{0.1}Se_{0.9}$ (5 nm) - ZnSe (5 nm), a Cl doped $Mg_{0.1}Zn_{0.9}S_{0.2}Se_{0.8}$ clad layer 22 (n = 1El8, 0.5 $\mu$m), a Cl doped $ZnS_{0.1}Se_{0.9}$ light guide layer 34 (n = 5El7, 0.1 $\mu$m), an undoped $Zn_{0.7}Cd_{0.3}Se$ active layer 44 (0.01 $\mu$m), an $N_2$ doped $ZnS_{0.1}Se_{0.9}$ light guide layer 43 (p = 5El7, 0.1 $\mu$m), an undoped $Mg_{0.1}Zn_{0.9}S_{0.2}Se_{0.8}$ clad layer 24 (p = 1El7, 1.0 $\mu$m), an $N_2$ doped $ZnS_{0.1}Se_{0.9}$ clad layer 7 (p

= 5El7, 0.5 $\mu$m) and a ZnSe cap layer 38 (p = 1El8, 0.1 $\mu$m). The surface of the sample was irradiated with molecular beams of Te for several tens min while keeping the sample temperature at the crystal growth temperature, and was then cooled to a temperature near room temperature. By this processing, a p-type ZnSeTe alloy with a gradient composition was formed on the surface of the sample. An $SiO_2$ film was formed on the sample by plasma CVD. The $SiO_2$ film was made in the form of a stripe having a width of about 5 $\mu$m using the known photolithography. A reverse mesa structure having a depth of about 1.5 $\mu$m was formed using a bromine based selective etching solution. This sample was then dipped in a $(NH_4)_2Sx$ solution for several min and cleaned by an alcohol based solvent, and it was put in the metal-organic vapor deposition system.

This sample was irradiated with hydrogen radicals while being heated at about 300°C to remove excessive sulfur. On the sample, an undoped $Mg_{0.2}Zn_{0.7}S_{0.3}Se_{0.7}$ block layer 46 (n = 1El4, 1.5 $\mu$m) was grown as a buried layer. Next, an $SiO_2$ film 12 was formed on the buried layer by plasma CVD, and a striped hole having a width of about 5 $\mu$m was formed on the $SiO_2$ film using the known photolithography.

Next, a Ti-Pt-Au multi-layer electrode 13 was deposited to a thickness of about 1 $\mu$m by vacuum vapor deposition. Moreover, an AuGe-Ni-Au multi-layer electrode 14 was deposited on the rear surface of the GaAs substrate which was polished to a thickness of 100 $\mu$m, after which the sample was cleaved to form a laser structure with a length of 1000 $\mu$m.

The device thus obtained was dipped in the $(NH_4)_2Sx$ solution for several min and cleaned with alcohol based solvent, and an SiNx-$SiO_2$ multi-layer reflection film was formed at the end surface of the resonator by sputtering.

The semiconductor laser of this structure is capable of continuously oscillating at room temperature a marine blue laser of a single vertical mode having a characteristic of a threshold current of 2 mA, a drive voltage 4V, and an oscillation wavelength of 500 nm.

(Embodiment 12)

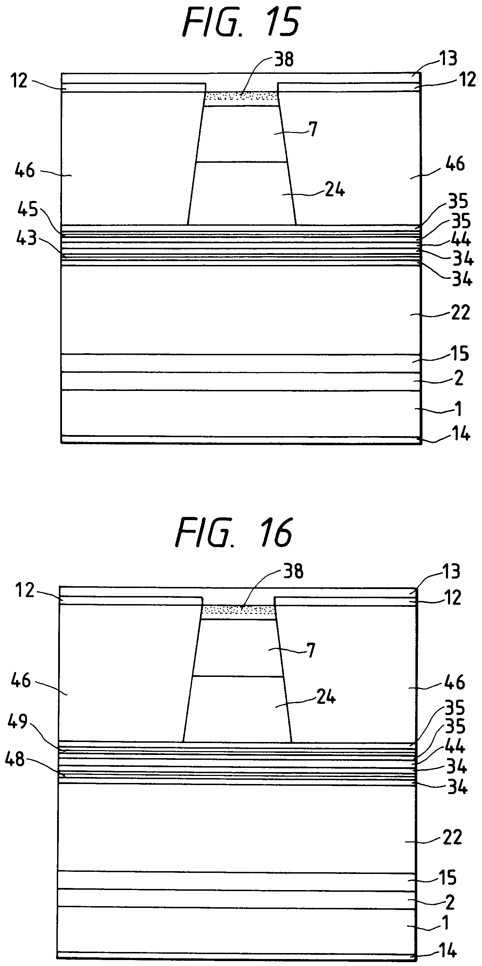

A twelfth embodiment of the present invention will be described with reference to Fig. 15. On an n-type GaAs substrate 1, there were sequentially grown by molecular beam epitaxy, an Se doped GaAs buffer layer 2 (n = 1El8, 0.5 $\mu$m), a Cl doped $ZnS_{0.1}Se_{0.9}$ clad layer 15 (n = 1El8, 0.1 $\mu$m), a Cl doped $Mg_{0.1}Zn_{0.9}S_{0.2}Se_{0.8}$ clad layer 22 (n = 1El8, 1.5 $\mu$m), a Cl doped $ZnS_{0.1}Se_{0.9}$ light guide layer 34 (n = 5El7, 0.5 $\mu$m), a supperlattice

light guide 43 (n = 5El7, 0.01 $\mu$m) of C$\ell$ doped ZnS$_{0.1}$Se$_{0.9}$ (10 nm) - Zn$_{0.7}$Cd$_{0.3}$S$_{0.1}$Se$_{0.9}$ (3 nm), a C$\ell$ doped ZnS$_{0.1}$Se$_{0.9}$ light guide layer 34 (n = 5El7, 0.5 $\mu$m), an undoped Zn$_{0.7}$Cd$_{0.3}$Se active layer 44 (0.01 $\mu$m), an N$_2$ doped ZnS$_{0.1}$Se$_{0.9}$ light guide layer 35 (p = 5El7, 0.05 $\mu$m), a supperlattice light guide 45 (n = 5El7, 0.01 $\mu$m) of N$_2$ doped ZnS$_{0.1}$Se$_{0.9}$ (10 nm) - Zn$_{0.7}$Cd$_{0.3}$S$_{0.1}$Se$_{0.9}$ (3 nm), an N$_2$ doped ZnS$_{0.1}$Se$_{0.9}$ light guide layer 35 (p = 5El7, 0.05 $\mu$m), an N$_2$ doped Mg$_{0.1}$Zn$_{0.9}$S$_{0.2}$Se$_{0.8}$ clad layer 24 (p = 1El7, 1.0 $\mu$m), an N$_2$ doped ZnS$_{0.1}$Se$_{0.9}$ clad layer 7 (p = 5El7, 0.5 $\mu$m) and a ZnSe cap layer 38 (p = 1El8, 0.1 $\mu$m). The surface of the sample was irradiated with molecular beams of Te for several tens min while keeping the sample temperature at the crystal growth temperature, and was then cooled to a temperature near room temperature. By this processing, a p-type ZnSeTe alloy with a gradient composition was formed on the surface of the sample. An SiO$_2$ film was formed on the sample by plasma CVD. The SiO$_2$ film was made in the form of a stripe having a width of about 5 $\mu$m using the known photolithography. A reverse mesa structure having a depth of about 1.5 $\mu$m was formed using a bromine based selective etching solution. This sample was then dipped in a (NH$_4$)$_2$Sx solution for several min and cleaned by an alcohol based solvent, and it was put in the metal-organic vapor deposition system.

This sample was irradiated with hydrogen radicals while being heated at about 300°C to remove excessive sulfur. On the sample, an undoped Mg$_{0.2}$Zn$_{0.7}$S$_{0.3}$Se$_{0.7}$ block layer 46 (n = 1El4, 1.5 $\mu$m) was grown as a buried layer. Next, an SiO$_2$ film 12 was formed on the buried layer by plasma CVD, and a striped hole having a width of about 5 $\mu$m was formed on the SiO$_2$ film using the known photolithography.

Next, a Ti-Pt-Au multi-layer electrode 13 was deposited to a thickness of about 1 $\mu$m by vacuum vapor deposition. Moreover, an AuGe-Ni-Au multi-layer electrode 14 was deposited on the rear surface of the GaAs substrate which was polished to a thickness of 100 $\mu$m, after which the sample was cleaved to form a laser structure with a length of 1000 $\mu$m.

The device thus obtained was dipped in the (NH$_4$)$_2$Sx solution for several min and cleaned with alcohol based solvent, and an SiNx-SiO$_2$ multi-layer reflection film was formed at the end surface of the resonator by sputtering.

The semiconductor laser of this structure is capable of continuously oscillating at room temperature a marine blue laser of a single vertical mode having a characteristic of a threshold current of 2 mA, a drive voltage 4V, and an oscillation wavelength of 500 nm.

(Embodiment 13)

A thirteenth embodiment of the present invention will be described with reference to Fig. 16. On an n-type GaAs substrate 1, there were sequentially grown by molecular beam epitaxy, an Se doped GaAs buffer layer 2 (n = 1El8, 0.5 $\mu$m), a C$\ell$ doped ZnS$_{0.1}$Se$_{0.9}$ clad layer 15 (n = 1El8, 0.1 $\mu$m), a C$\ell$ doped Mg$_{0.1}$Zn$_{0.9}$S$_{0.2}$Se$_{0.8}$ clad layer 22 (n = 1El8, 1.5 $\mu$m), a C$\ell$ doped ZnS$_{0.1}$Se$_{0.9}$ light guide layer 34 (n = 5El7, 0.5 $\mu$m), a supperlattice light guide 48 (n = 5El7, 0.01 $\mu$m) of C$\ell$ doped ZnS$_{0.1}$Se$_{0.9}$ (5 nm) - ZnSe (5 nm), a C$\ell$ doped ZnS$_{0.1}$Se$_{0.9}$ light guide layer 34 (n = 5El7, 0.5 $\mu$m), an undoped Zn$_{0.7}$Cd$_{0.3}$Se active layer 44 (0.01 $\mu$m), an N$_2$ doped ZnS$_{0.1}$Se$_{0.9}$ light guide layer 35 (p = 5El7, 0.05 $\mu$m), a supperlattice light guide 49 (p = 5El7, 0.01 $\mu$m) of N$_2$ doped ZnS$_{0.1}$Se$_{0.9}$ (5 nm) - ZnSe (5 nm), an N$_2$ doped ZnS$_{0.1}$Se$_{0.9}$ light guide layer 35 (p = 5El7, 0.05 $\mu$m), an N$_2$ doped Mg$_{0.1}$Zn$_{0.9}$S$_{0.2}$Se$_{0.8}$ clad layer 24 (p = 1El7, 1.0 $\mu$m), an N$_2$ doped ZnS$_{0.1}$Se$_{0.9}$ clad layer 7 (p = 5El7, 0.5 $\mu$m) and a ZnSe cap layer 38 (p = 1El8, 0.1 $\mu$m). The surface of the sample was irradiated with molecular beams of Te for several tens min while keeping the sample temperature at the crystal growth temperature, and was then cooled to a temperature near room temperature. By this processing, a p-type ZnSeTe alloy with a gradient composition was formed on the surface of the sample. An SiO$_2$ film was formed on the sample by plasma CVD. The SiO$_2$ film was made in the form of a stripe having a width of about 5 $\mu$m using the known photolithography. A reverse mesa structure having a depth of about 1.5 $\mu$m was formed using a bromine based selective etching solution. This sample was then dipped in a (NH$_4$)$_2$Sx solution for several min and cleaned by an alcohol based solvent, and it was put in the metal-organic vapor deposition system.

This sample was irradiated with hydrogen radicals while being heated at about 300°C to remove excessive sulfur. On the sample, an undoped Mg$_{0.2}$Zn$_{0.7}$S$_{0.3}$Se$_{0.7}$ block layer 46 (n = 1El4, 1.5 $\mu$m) was grown as a buried layer. Next, an SiO$_2$ film 12 was formed on the buried layer by plasma CVD, and a striped hole having a width of about 5 $\mu$m was formed on the SiO$_2$ film using the known photolithography.

Next, a Ti-Pt-Au multi-layer electrode 13 was deposited to a thickness of about 1 $\mu$m by vacuum vapor deposition. Moreover, an AuGe-Ni-Au multi-layer electrode 14 was deposited on the rear surface of the GaAs substrate which was polished to a thickness of 100 $\mu$m, after which the sample was cleaved to form a laser structure with a length of 1000 $\mu$m.

The device thus obtained was dipped in the $(NH_4)_2Sx$ solution for several min and cleaned with alcohol based solvent, and an SiNx-SiO$_2$ multi-layer reflection film was formed at the end surface of the resonator by sputtering.

The semiconductor laser of this structure is capable of continuously oscillating at room temperature a marine blue laser of a single vertical mode having a characteristic of a threshold current of 2 mA, a drive voltage 4V, and an oscillation wavelength of 500 nm.

According to the present invention, there can be provided a short wave II-VI compound semiconductor laser with a high reliability, which is capable of reducing the threshold current, lowering the contact resistance of an electrode, and reducing the lattice strain due to thermal expansion; and which is capable of continuously oscillating a laser at room temperature by the improvement in the confinement of injected charge and light.

## Claims

1. A buried type semiconductor laser device comprising a II-VI compound semiconductor, wherein a buried layer (9 to 11, 19, 33, 37, 41, 42, 46) is made of a II-VI compound semiconductor having a refraction factor lower than that of an active layer (6, 17, 23, 44) of said laser device.

2. A semiconductor laser device according to claim 1, wherein said buried layer is made of a II-VI compound semiconductor having a forbidden band width larger than that of an active layer of said laser device.

3. A semiconductor laser device according to claim 1, wherein said buried layer is made of a II-VI compound semiconductor having such a composition that the lattice constant thereof is substantially matched to that of a substrate (1) on which said laser device is grown.

4. A semiconductor laser device according to claim 1, wherein said buried layer is made of a II-VI compound semiconductor having an electric resistance high enough not to exert an effect on the operation of the laser composed of an n-type clad-active layer-a p-type clad (4-6-7, 15-17-18, 39-23-40, 22-17-24).

5. A semiconductor laser device according to claim 1, wherein said buried layer is made of a II-VI compound semiconductor (9, 10) having a conducting type opposed to that of a clad layer (4, 7) being horizontally contacted with the surface of a substrate or to that of an active layer.

6. A method of forming a thin film comprising the steps of:
    forming sulfur atoms or a layer of sulfur atoms on a II-VI compound semiconductor;
    introducing said II-VI compound semiconductor in a thin film deposition apparatus;
    removing said sulfur atoms or a layer of sulfur atoms by a suitable amount using electromagnetic wave, corpuscular beam, heat or solution; and
    growing or depositing a new material such as a II-VI compound semiconductor, a III-V compound, a IV compound, a IV-VI compound, or a II-VII compound.

7. A method of forming a thin film according to claim 6, wherein said sulfur atoms or a layer of sulfur atoms formed on said II-VI compound semiconductor are removed at a temperature of 400 °C or less, and a new material such as a II-VI compound semiconductor, a III-V compound, a IV compound, a IV-VI compound, or a II-VII compound is grown or deposited on the exposed surface.

8. A method of fabricating a buried type semiconductor laser device composed of a II-VI compound semiconductor, comprising the steps of:
    forming a mesa structure by etching; and
    forming a buried layer according to said thin film forming method described in claim 6.

9. A semiconductor laser device composed of a II-VI compound semiconductor, wherein a material, which is used for formation of a protection film or multi-layer reflection film at the end surface of a resonator, contains at least one kind or more of II-VI compounds having a forbidden band width larger than that of an active layer, such as ZnS or MgS.

10. A semiconductor laser device composed of a II-VI compound semiconductor, wherein a material, which is used for formation of a protection film or multi-layer reflection film at the end surface of a resonator, contains at least one kind or more of IV-VI compounds having a forbidden band width larger than that of an active layer, such as SiO$_2$ or TiO$_2$.

11. A semiconductor laser device composed of a II-VI compound semiconductor, wherein a material, which is used for formation of a protection film or multi-layer reflection film at the end surface of a resonator, contains at least one kind or more of II-VII compounds having a forbidden band width larger than that of an active layer, such as MgF$_2$ or CaF$_2$.

12. A semiconductor laser device composed of a II-VI compound semiconductor, wherein a material, which is used for formation of a protection film or multi-layer reflection film at the end surface of a resonator, contains at least one kind or more of IV compounds having a forbidden band width larger than that of an active layer, such as C, SiCx or SiNx.

13. A method of fabricating a semiconductor laser device composed of a II-VI compound semiconductor, comprising the steps of;

    forming a film to the end surface of a resonator of said laser device according to said thin film forming method described in claim 6; and

    forming a protection film or multi-layer reflection film.

14. A method of forming an electrode to a II-VI compound semiconductor, comprising the steps of:

    growing a layer including a CdSSe alloy on said II-VI compound semiconductor as a cap layer (8); and

    depositing a metal film (13) as an electrode on said layer.

15. A method of forming an electrode to a II-VI compound semiconductor, comprising the steps of:

    exposing said II-VI compound semiconductor to a molecular beam or a gas containing Cd or Te in a crystal growth apparatus; and

    depositing a metal film (13) as an electrode on the processed surface.

16. A method of forming an electrode according to claim 14, wherein a thin film is formed on the surface of said II-VI compound semiconductor according to said thin film forming method described in claim 6 or 7, before deposition of a metal film as an electrode.

17. A semiconductor device composed of a II-VI compound semiconductor, which is epitaxially grown on a substrate[(1)] made of a IV such as Si or a III-V compound semiconductor such as GaAs or InP, said device having a structure that a strained superlattice (3, 47) including at least one thin film of II-VI compound semiconductor is introduced in the hetero-interface as a region for reducing a strain caused by thermal expansion or contraction.

18. A semiconductor laser device composed of a II-VI compound semiconductor fabricated on a IV or a III-V compound semiconductor substrate (1), which has said structure described in claim 17 at the hetero-interface.

19. A double hetero type semiconductor laser device using a II-VI compound semiconductor composed of an alloy of ZnMgCdSSe, comprising an n-type clad layer, a p-type clad layer and an active layer,

    wherein each of said n-type and p-type clad layers has a lattice constant substantially matched to that of a substrate crystal or a buffer layer formed at the hetero-interface, and which has a forbidden band width larger than that of an active layer;

    said n-type and p-type clad layers are different in the alloy composition from each other; and

    the difference ($\Delta$Ev = Ev$_{act}$ - Ev$_{clad}$) in the energy of the valency electron band between said n-type clad layer and said active layer is positive, and the difference ($\Delta$Ec = Ec$_{clad}$ - Ec$_{act}$) in the energy of the conducting band between said p-type clad layer and said active layer is positive.

20. A semiconductor laser device having a GRIN-SCH structure using a II-VI compound semiconductor, wherein a light guide layer (16, 18) is made of a superlattice.

21. A semiconductor laser device composed of a II-VI compound semiconductor fabricated on a IV or a III-V compound semiconductor substrate (1), which has at the hetero-interface a superlattice structure (47) composed of an alloy layer of ZnS$_x$Se$_{1-x}$ (0$\leqq$x$\leqq$1) having a thickness of 10 nm or less and an alloy layer of Zn$_y$Cd$_{1-y}$S$_{x'}$Se$_{1-x'}$ (0$\leqq$x'$\leqq$1, 0$\leqq$y$\leqq$1) having a thickness of 10 nm or less.

22. A semiconductor laser device composed of a II-VI compound semiconductor fabricated on a IV or a III-V compound semiconductor substrate (1) which has at the hetero-interface a superlattice structure (3) composed of an alloy layer of ZnS$_x$Se$_{1-x}$ (0$\leqq$x$\leqq$1) having a thickness of 10 nm or less and an alloy layer of ZnSe having a thickness of 10 nm or less.

23. A semiconductor laser device composed of a II-VI compound semiconductor fabricated on a IV or a III-V compound semiconductor substrate (1), which has at a portion adjacent to the active layer (44), a superlattice structure (43, 45) composed of an alloy layer of

$ZnS_xSe_{1-x}$ (0≤x≤1) having a thickness of 10 nm or less and an alloy layer of $Zn_yCd_{1-y}S_{x'}Se_{1-x'}$ (0≤x'≤1, 0≤y≤1) having a thickness of 10 nm or less.

24. A semiconductor laser device composed of a II-VI compound semiconductor fabricated on a IV or a III-V compound semiconductor substrate (1), which has at a portion adjacent to an active layer (44) a superlattice structure (48, 49) composed of an alloy layer of $ZnS_xSe_{1-x}$ (0≤x≤1) having a thickness of 10 nm or less and an alloy layer of ZnSe having a thickness of 10 nm or less.

25. A semiconductor laser device composed of a II-VI compound semiconductor fabricated on a IV or a III-V compound semiconductor substrate (1) which has at the heterointerface between a clad layer (22, 24) and a light guide layer (34, 35), a superlattice structure (43, 45) composed of an alloy layer of $ZnS_xSe_{1-x}$ (0≤x≤1) having a thickness of 10 nm or less and an alloy layer of $Zn_yCd_{1-y}S_{x'}Se_{1-x'}$ (0≤x'≤1, 0≤y≤1) having a thickness of 10 nm or less.

26. A semiconductor laser device composed of a II-VI compound semiconductor fabricated on a IV or a III-V compound semiconductor substrate, which has at the hetero-interface between a clad layer (22, 24) and a light guide layer (34, 35), a superlattice structure (48, 49) composed of an alloy layer of $ZnS_xSe_{1-x}$ (0≤x≤1) having a thickness of 10 nm or less and an alloy layer of ZnSe having a thickness of 10 nm or less.

27. A semiconductor laser device composed of a II-VI compound semiconductor fabricated on a IV or a III-V compound semiconductor substrate (1), which has in a light guide layer a superlattice structure (43, 45) composed of an alloy layer of $ZnS_xSe_{1-x}$ (0≤x≤1) having a thickness of 10 nm or less and an alloy layer of $Zn_yCd_{1-y}S_{x'}Se_{1-x'}$ (0≤x'≤1, 0≤y≤1) having a thickness of 10 nm or less.

28. A semiconductor laser device composed of a II-VI compound semiconductor fabricated on a IV or a III-V compound semiconductor substrate (1) which has in a light guide layer a superlattice structure (48, 49) composed of an alloy layer of $ZnS_xSe_{1-x}$ (0≤x≤1) having a thickness of 10 nm or less and an alloy layer of ZnSe having a thickness of 10 nm or less.

29. A semiconductor laser device composed of a II-VI compound semiconductor fabricated on a IV or a III-V compound semiconductor substrate (1), which has in a clad layer a superlattice structure (47) composed of an alloy layer of $ZnS_xSe_{1-x}$ (0≤x≤1) having a thickness of 10 nm or less and an alloy layer of $Zn_yCd_{1-y}S_{x'}Se_{1-x'}$ (0≤x'≤1, 0≤y≤1) having a thickness of 10 nm or less.

30. A semiconductor laser device composed of a II-VI compound semiconductor fabricated on a IV or a III-V compound semiconductor substrate (1), which has in a clad layer a superlattice structure (47) composed of an alloy layer of $ZnS_xSe_{1-x}$ (0≤x≤1) having a thickness of 10 nm or less and an alloy layer of ZnSe having a thickness of 10 nm or less.

## FIG. 1

## FIG. 2

# FIG. 3

# FIG. 4

EP 0 637 862 A2

FIG. 5

FIG. 6

17

# FIG. 7

# FIG. 8

## FIG. 9

## FIG. 10

## FIG. 11

## FIG. 12

## FIG. 13

## FIG. 14

# FIG. 15

# FIG. 16